# EUROPEAN PATENT APPLICATION

(11) **EP 4 618 238 A1**
(43) Date of publication of application: **17.09.2025**
(21) Application number: 23890119.3
(22) Date of filing: 26.05.2023
(51) Int. Cl.: H01M 10/613, H01M 10/6556, H01M 10/6568, H01M 10/655, H01M 10/633, H01M 10/635, H01M 10/6569, H01M 10/6563, H05K 7/20

(54) **THERMAL MANAGEMENT SYSTEM AND CONTROL METHOD THEREOF**

(30) Priority: 16.11.2022 CN 202211433264; 08.05.2023 CN 202310512952
(71) Applicant: Sungrow Power Supply Co., Ltd., Hefei, Anhui 230088 (CN)
(72) Inventor: BAO, Tong, Hefei, Anhui 230088 (CN)
(74) Representative: Rooney, John-Paul
(86) International application number: PCT/CN2023/096452
(87) International publication number: WO 2024/103675

(57) **Abstract**

Disclosed in the present invention are a thermal management system and a control method. The thermal management system comprises: a first liquid pipeline, a second liquid pipeline and a switching valve group, the switching valve group being connected between the first liquid pipeline and the second liquid pipeline. The switching valve group can be switched back and forth between a first working position and a second working position; when the switching valve group is at the first working position, a circulation loop where the first liquid pipeline is located and a circulation loop where the second liquid pipeline is located are two circulation loops of which liquid flow circulations do not interfere with each other; and, when the switching valve group is at the second working position, the first liquid pipeline and the second liquid pipeline form a series circulation loop. The thermal management system can meet the working requirements of a device corresponding to a first heat exchanger and a device corresponding to a second heat exchanger with more economical energy consumption, thus improving the overall energy efficiency of the thermal management system. In addition, integrated management of the first heat exchanger and the second heat exchanger significantly improves the integration level of the unit.

## Description

The present application claims the priorities to the Chinese Patent Application No. 202211433264.7, titled "THERMAL MANAGEMENT SYSTEM AND CONTROL METHOD THEREOF", filed on November 16, 2022 with the China National Intellectual Property Administration and the Chinese Patent Application No. 202310512952.0, titled "THERMAL MANAGEMENT SYSTEM AND CONTROL METHOD", filed on May 8, 2023 with the China National Intellectual Property Administration, both of which are incorporated herein by reference in their entireties.

### FIELD

The present application relates to the technical field of thermal management, and in particular to a thermal management system and a control method.

### BACKGROUND

The strong wind of clean energy blows around the world, and lithium-ion energy storage batteries have garnered extensive research and attention due to their high energy density, low self-discharge rate, and long cycle life.

Currently, string-type energy storage systems typically employ air-cooled power conversion systems (PCS) equipped with liquid-cooled battery packs for battery charge and discharge management. As the battery capacity of the energy storage systems continues to increase, however, the load on the power conversion systems also increases, making air-cooling dissipation insufficient to the performance requirements of the conversion systems. Consequently, there is a growing demand for the liquid-cooled power conversion systems. The currently prevalent arrangement for the liquid-cooled energy storage systems involves arranging a separate liquid-cooling unit for the power conversion system. This arrangement suffers from poor overall energy efficiency and low integration of the system. Similarly, the thermal management systems for other devices with two different cooling requirements also face similar issues.

In summary, how to solve the problems of poor overall energy efficiency and low integration in the thermal management systems has become an urgent task for those skilled in the art.

### SUMMARY

In view of this, a thermal management system and a control method are provided according to the present application to solve the problems of poor overall energy efficiency and low integration of the system.

In order to implement the above objectives, the following technical solutions are provided according to the present application.

A thermal management system includes a first liquid pipeline, a second liquid pipeline and a switching valve group. A first heat exchange unit, a first circulation pump and a first heat exchange device are connected in series on the first liquid pipeline. A second heat exchange unit, a second circulation pump and a second heat exchange device are connected in series on the second liquid pipeline. The switching valve group is connected between the first liquid pipeline and the second liquid pipeline;
the switching valve group can be switched between a first working position and a second working position. In a case that the switching valve group is in the first working position, liquid flow circulations of the first liquid pipeline and the second liquid pipeline do not interfere with each other. In a case that the switching valve group is in the second working position, the first liquid pipeline and the second liquid pipeline are connected in series to form a circulation loop.

Optionally, the switching valve group includes a first valve port, a second valve port, a third valve port and a fourth valve port. Both ends of the first liquid pipeline are respectively connected to the first valve port and the second valve port, and both ends of the second liquid pipeline are respectively connected to the third valve port and the fourth valve port;
in a case that the switching valve group is in the first working position, the first valve port is communicated to the second valve port, and the third valve port is communicated to the fourth valve port; in a case that the switching valve group is in the second working position, the second valve port is communicated to the third valve port, and the first valve port is communicated to the fourth valve port.

Optionally, the first liquid pipeline is further provided with a heater, which is located between a liquid outlet of the first heat exchange unit and a liquid inlet of the first heat exchange device.

Optionally, a refrigeration unit is further included. The first heat exchange unit is configured as an evaporator of the refrigeration unit. The condenser of the refrigeration unit is connected in series on the second liquid pipeline and located upstream of the second heat exchange device, while the second heat exchange unit is located downstream of the second heat exchange device.

Optionally, the condenser is configured as a plate heat exchanger, and the second heat exchange unit is configured as an air-cooled condenser.

Optionally, the second liquid pipeline is further provided with a bypass pipeline arranged in parallel with the second heat exchange unit.

Optionally, the liquid inlet of the bypass pipeline is connected with the second liquid pipeline through a three-way valve, and the three-way valve is configured to be switched between a first communication status and a second communication status;
in a case that the three-way valve is in the first communication status, the bypass pipeline is communicated, and the second heat exchange unit is in short-circuited on the second liquid pipeline; in a case that the three-way valve is in the second communication status, the bypass pipeline is cut off, and the second heat exchange unit is connected to the second liquid pipeline.

Optionally, the thermal management system is applied onto a liquid-cooled energy storage unit, the first heat exchange device is arranged in heat exchange with the battery pack of the liquid-cooled energy storage unit, and the second heat exchange device is arranged in heat exchange with the converter of the liquid-cooled energy storage unit.

Optionally, in a case that the switching valve group is in the second working position, the first heat exchange device and the second heat exchange device are sequentially arranged on the liquid flow pipeline between the liquid outlet of the first heat exchange unit and the liquid inlet of the first heat exchange unit, and the first heat exchange device is located upstream of the second heat exchange device.

Compare with the description in background technology, the above thermal management system includes the first liquid pipeline, the second liquid pipeline and the switching valve group. The first heat exchange unit, the first circulation pump and the first heat exchange device are connected in series on the first liquid pipeline. The second heat exchange unit, the second circulation pump and the second heat exchange device are connected in series on the second liquid pipeline. The switching valve group is connected between the first liquid pipeline and the second liquid pipeline. The switching valve group is configured to be switched between the first working position and the second working position. In a case that the switching valve group is in the first working position, the circulation loop having the first liquid pipeline and the circulation loop having the second liquid pipeline are two circulation loops in which liquid flow circulations do not interfere with each other. In a case that the switching valve group is in the second working position, the first liquid pipeline and the second liquid pipeline form the series circulation loop. In a practical application process, the thermal management system may change the circulation loop mode of the first liquid pipeline and the second liquid pipeline by controlling the working position of the switching valve group. Specifically, taking the heat exchange arrangement of the first heat exchange device and the second heat exchange device with heating devices with different cooling requirements as an example, in a case that the switching valve group is in the first working position, the circulation loop having the first liquid pipeline and the circulation loop having the second liquid pipeline are two circulation loops in which liquid flow circulations do not interfere with each other. At this time, cooling capacity from the first heat exchange unit may be delivered to the first heat exchange device through the first circulation pump, so as to cool down the corresponding heating devices through the first heat exchange device, and cooling capacity from the second heat exchange unit may be delivered to the second heat exchange device through the second circulation pump, so as to cool down the corresponding heating devices through the second heat exchange device. In a case that the switching valve group is in the second working position, the first liquid pipeline and the second liquid pipeline form the series circulating loop. At this time, both of the cooling capacity from the first heat exchange unit and the cooling capacity from the second heat exchange unit may be delivered to the first heat exchange device and the second heat exchange device under circulation power of the first circulation pump and the second circulation pump, and then the corresponding heating devices of the first heat exchange device and the second heat exchange device may be cooled down at the same time. Similarly, working principle of the heat exchange arrangement of the first heat exchange device and the second heat exchange device with related devices with different heating requirements is similar to that of the heat exchange arrangement of the first heat exchange device and the second heat exchange device with heating devices with different cooling requirements, and the only difference is that the cooling requirement and heating requirement are different. Due to the above thermal management system, two working positions may be switched based on heat dissipation requirements of the heating devices corresponding to the first heat exchange device and the second heat exchange device. For example, in a case that the heat dissipation requirements of the two heating devices are quite different, the switching valve group can be switched to the first working position, and in a case that the heat dissipation requirements of the two heating devices are relatively small, the switching valve group can be switched to the second working position. Therefore, the working requirements of the heating device corresponding to the first heat exchange device and the heating device corresponding to the second heat exchange device are met with more economical energy consumption, and then the energy efficiency of the whole thermal management system is improved. In this case, the first heat exchange device and the second heat exchange device are managed in an integrated way, which greatly improves the integration degree of the system.

In addition, a control method for controlling the thermal management system described in any of the above solutions is further provided according to the present application, which specifically includes:
acquiring external ambient temperature of the equipment applied by the thermal management system;
and in a case that the external environment temperature is greater than a first preset temperature value, the switching valve group is controlled to switch to a first working position, and in a case that the external environment temperature is less than the first preset temperature value, the switching valve group is controlled to switch to a second working position.

Since the above thermal management system has the above technical effects, the control method used for the thermal management system should also have corresponding technical effects, which will not be repeated here.

Optionally, the first preset temperature value refers to a liquid return temperature of the first heat exchange unit or a temperature value lower than the preset liquid return temperature of the first heat exchange unit.

Optionally, in a case that the second liquid pipeline is provided with a bypass pipeline arranged in parallel with the second heat exchange unit, the external environment temperature is less than the first preset temperature value, and in a case that the device applied by the thermal management system is in a startup condition or runs below the second preset temperature value for more than a preset time, the first bypass pipeline is opened.

Optionally, in a case that the external ambient temperature is lower than a first preset temperature value and the device using the thermal management system is in a static state, the first heat exchange unit is closed and the pipeline where the second heat exchange unit is located remains open.

### BRIEF DESCRIPTION OF THE DRAWINGS

For more clearly illustrating embodiments of the present application or technical solutions in the conventional technology, the drawings referred to for describing the embodiments or the conventional technology will be briefly described hereinafter. Apparently, the drawings in the following description are only some examples of the present application, and for those skilled in the art, other drawings may be obtained based on the provided drawing without any creative efforts.
FIG. 1 is a schematic structural view of a thermal management system of an energy storage unit provided according to an embodiment of the present application in a case that a switching valve group is in a first working position;
FIG. 2 is a schematic structural view of a thermal management system of an energy storage unit provided according to an embodiment of the present application in a case that a switching valve group is in a second working position;
FIG. 3 is a schematic structural view of a thermal management system of an energy storage unit provided according to an embodiment of the present application in a case that a condenser of a refrigeration unit is connected in series to a second liquid pipeline and a switching valve group is in a first working position;
FIG. 4 is a schematic structural view of a thermal management system of an energy storage unit provided according to an embodiment of the present application in a case that a condenser of a refrigeration unit is connected in series to a second liquid pipeline and a switching valve group is in a second working position.

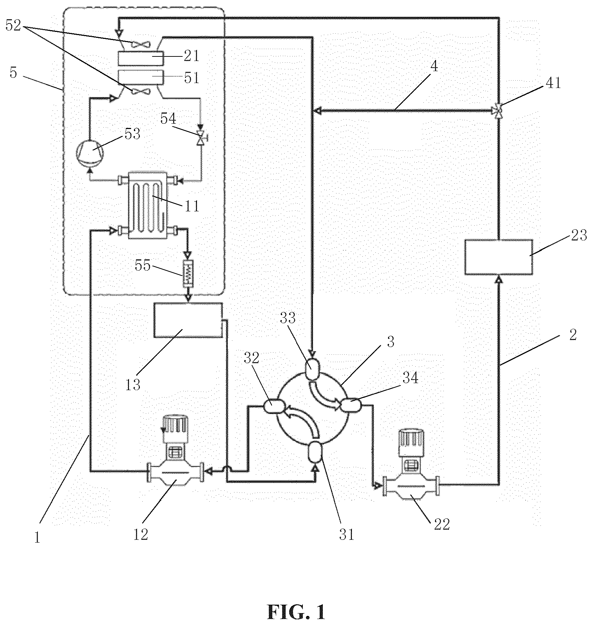

Reference numerals in FIG. 1 to FIG. 4 are listed as follows:
1 first fluid pipeline, 11 first heat exchange unit, 12 first circulation pump, 13 first heat exchange device;
2 second fluid pipeline, 21 second heat exchange unit, 22 second circulation pump, 23 second heat exchange device;
3 switching valve group, 31 first valve port, 32 second valve port, 33 third valve port, 34 fourth valve port, 4 bypass pipeline, 41 three-way valve;
5 refrigeration unit, 51 condenser, 52 heat-dissipation fan, 53 compressor, 54 throttle valve, 55 heater.

### DETAILED DESCRIPTION OF THE EMBODIMENTS

A core of the present application is to provide a thermal management system and a control method, so as to solve the problems of poor overall energy efficiency and low integration of the system.

Technical solutions of embodiments of the present application are clearly and completely described hereinafter in conjunction with the drawings of the embodiments of the present application. Apparently, the embodiments described are only some embodiments of the present application, rather than all embodiments. Any other embodiments obtained by those skilled in the art based on the embodiments of the present application without any creative work fall within the protection scope of the present application.

A thermal management system of an energy storage unit is provided according to the present application. With reference to FIGS. 1 to 4, it specifically includes a first liquid pipeline 1, a second liquid pipeline 2 and a switching valve group 3. A first heat exchange unit 11, a first circulation pump 12 and a first heat exchange device 13 are connected in series on the first liquid pipeline 1. A second heat exchange unit 21, a second circulation pump 22 and a second heat exchange device 23 are connected in series on the second liquid pipeline 2. The switching valve group 3 is connected between the first liquid pipeline 1 and the second liquid pipeline 2. The switching valve group 3 may be switched between a first working position and a second working position. In a case that the switching valve group 3 is in the first working position, liquid flow circulations of the first liquid pipeline 1 and the second liquid pipeline 2 do not interfere with each other. In a case that the switching valve group 3 is in the second working position, the first liquid pipeline 1 and the second liquid pipeline 2 are connected in series to form a circulation loop.

In a practical application process, the thermal management system may change circulation loop mode of the first liquid pipeline 1 and the second liquid pipeline 2 by controlling the working position of the switching valve group 3. Specifically, for example, the first heat exchange device 13 and the second heat exchange device 23 have to respectively exchange with heating devices having different cooling requirements, in a case that the switching valve group 3 is in the first working position, the circulation loop having the first liquid pipeline 1 and the circulation loop having the second liquid pipeline 2 are two circulation loops in which liquid flow circulations do not interfere with each other. In this case, cooling capacity from the first heat exchange unit 11 may be delivered to the first heat exchange device 13 through the first circulation pump 12, so as to cool down the corresponding heating devices through the first heat exchange device 13, and cooling capacity from the second heat exchange unit 21 may be delivered to the second heat exchange device 23 through the second circulation pump 22, so as to cool down the corresponding heating devices through the second heat exchange device 23; in a case that the switching valve group 3 is in the second working position, the first liquid pipeline 1 and the second liquid pipeline 2 are connected in series to form a circulation loop, at this time, both of the cooling capacity from the first heat exchange unit 11 and the cooling capacity from the second heat exchange unit 21 may be delivered to the first heat exchange device 13 and the second heat exchange device 23 under circulation power of the first circulation pump 12 and the second circulation pump 22, and then the corresponding heating devices of the first heat exchange device 13 and the second heat exchange device 23 may be cooled down at the same time. Similarly, working principle of the heat exchange arrangement of the first heat exchange device 13 and the second heat exchange device 23 with related devices having different heating requirements is similar to that of the heat exchange arrangement of the first heat exchange device 13 and the second heat exchange device 23 with heating devices having different cooling requirements, and the only difference is that the cooling requirement and heating requirement. Due to the above thermal management system, two working positions may be switched based on heat dissipation requirements of the heating devices corresponding to the first heat exchange device 13 and the second heat exchange device 23. For example, in a case that the heat dissipation requirements of the two heating devices are quite different, the switching valve group 3 may be switched to the first working position, and in a case that the heat dissipation requirements of the two heating devices are relatively small, the switching valve group 3 may be switched to the second working position. Therefore, the working requirements of the heating device corresponding to the first heat exchange device 13 and the heating device corresponding to the second heat exchange device 23 are met through more economical energy consumption, and then the energy efficiency of the whole thermal management system is improved. In this case, the first heat exchange device 13 and the second heat exchange device 23 are controlled in an integrated way, which greatly improves the integration degree of the system.

It should be noted that the heating device corresponding to the first heat exchange device 13 and the heating device corresponding to the second heat exchange device 23 have different temperature tolerance and different requirements for heat dissipation boundary conditions, so they have different refrigeration capacity requirements. For example, in a case that the thermal management system is applied onto a liquid-cooled energy storage unit, the first heat exchange device 13 may be arranged to exchange heat with the battery pack in the liquid-cooled energy storage unit, and the second heat exchange device 23 may be arranged to exchange heat with the converter in the liquid-cooled energy storage unit. The battery pack is more sensitive to temperature, so the required refrigeration capacity and refrigeration speed are more demanding, while the converter has a relatively high tolerance to temperature, and the demand for refrigeration capacity and refrigeration speed is relatively low. In addition, it should be noted that the refrigeration modes and/or refrigeration capacity of the first heat exchange unit 11 and the second heat exchange unit 21 are generally different, and may be specifically configured based on actual needs in the actual application process.

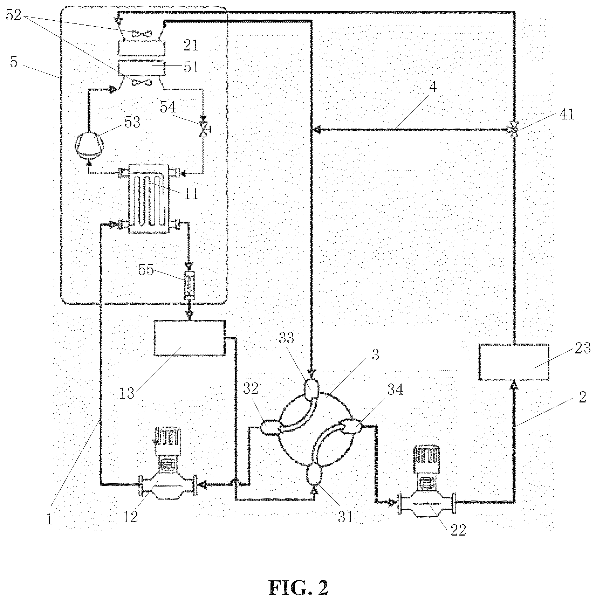

For example, the first heat exchange unit 11 may be an evaporator of the refrigeration unit 5, which includes a refrigerant flow channel and a liquid cooling flow channel in heat exchange arrangement with the refrigerant flow channel, and the liquid cooling flow channel is connected in series on the first liquid pipeline 1. The coolant in the liquid cooling flow channel is cooled by evaporating and vaporizing the refrigerant in the refrigerant flow channel of the evaporator of the refrigeration unit 5. It should be understood by those skilled in the art that the refrigeration unit 5 generally includes a condenser 51, a compressor 53 and a throttle valve 54 in addition to the evaporator. It should be noted that the corresponding side of the condenser 51 may be provided with a heat-dissipation fan 52 as shown in FIGS. 1 and 2.

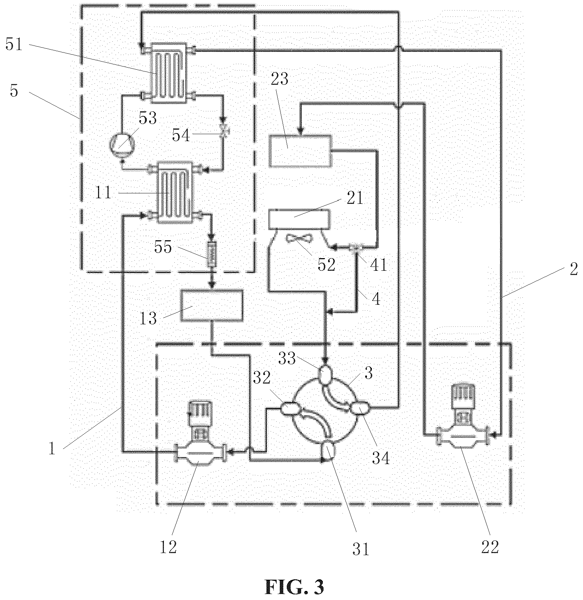

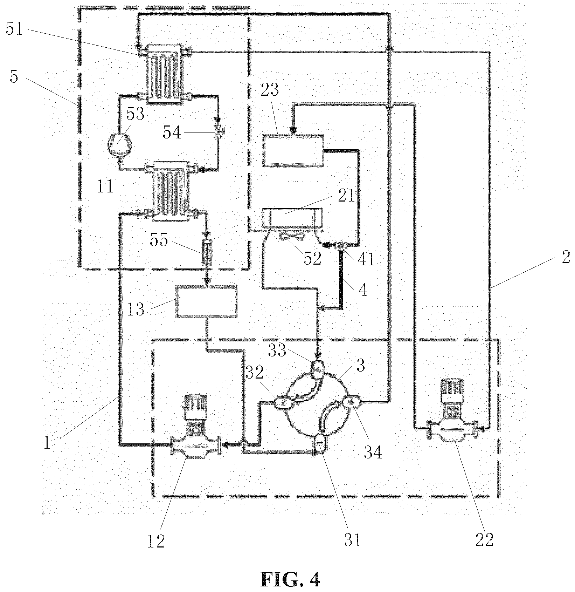

In addition, as shown in FIGS. 3 and 4, the condenser 51 of the refrigeration unit 5 may be connected in series to the second liquid pipeline 2 and located upstream of the second heat exchange device 23, and the second heat exchange unit 21 is located downstream of the second heat exchange device 23. It should be noted that those skilled in the art should understand that in a case that the condenser 51 is connected in series to the second liquid pipeline 2, the condenser 51 at this time has a refrigerant flow channel and a coolant flow channel in heat exchange arrangement with the refrigerant flow channel, where the refrigerant flow channel is connected in series to the refrigerant circulation pipeline of the refrigeration unit 5 and the coolant flow channel is connected in series to the second liquid pipeline 2.

By connecting the condenser 51 in series with the second liquid pipeline 2, as shown in FIG. 3, in a case that the device is in a high-temperature working condition, the switching valve group 3 is switched to the first working position. In this case, the refrigeration capacity of the refrigeration unit 5 is completely used for cooling the first heat exchange device 13, and the heat of the condenser 51 may be quickly taken away by the coolant in the second liquid pipeline 2, so that the heat exchange efficiency of the evaporator of the refrigeration unit 5, that is, the first heat exchange unit 11, may be improved, and the heat exchange effect on the first heat exchange device 13 may be improved. In addition, the second heat exchange device 23 generally located on the second liquid pipeline 2 has better temperature resistance than the first heat exchange device 13. Therefore, by arranging the second heat exchange unit 21 downstream of the second heat exchange device 23, the temperature of the coolant delivered to the condenser 51 may be ensured to be relatively low on the premise of ensuring a certain heat dissipation function for the second heat exchange device 23.

With reference to FIG. 4, in a case that the device is in a middle-low temperature working condition, the switching valve group 3 is switched to the second working position, that is, the first liquid pipeline 1 and the second liquid pipeline 2 are connected in series to form a circulation loop. At this time, the refrigeration capacity of the refrigeration unit 5 is partly used for cooling the first heat exchange device 13 and partly used for cooling the second heat exchange device 23.

In some specific embodiments, the condenser may be specifically configured as a plate heat exchanger, but it can be understood that other heat exchanger structures may also be adopted, which is not specifically limited here. In addition, the second heat exchange unit 21 may be configured as an air-cooled condenser or other radiator structures, and is not specifically limited here.

In addition, the first liquid pipeline 1 may also be provided with a heater 55, which is located between a liquid outlet of the first heat exchange unit 11 and a liquid inlet of the first heat exchange device 13, so as to avoid the cooling liquid temperature in the liquid cooling channel being too low. The specific structure of the heater 55 may adopt a heating rod, but it is not limited to the heating rod, and other heaters with heating function may also be used.

For another example, the second heat exchange unit 21 may be connected in series with a dry cooler of the second liquid pipeline 2. Compared with the refrigerant refrigeration mode, the dry cooler has lower energy consumption and better energy efficiency ratio, but the refrigeration speed and refrigeration capacity are lower than that of the refrigerant refrigeration.

Similarly, in a case that the related devices corresponding to the first heat exchange device 13 and the related devices corresponding to the second heat exchange device 23 are devices having heating requirements, they have different low-temperature tolerance, and working principles are similar, except that the former is cooling and the latter is heating, which is not be described here.

In a further embodiment, in a case that the first heat exchange unit 11 is an evaporator of the refrigeration unit 5 and the second heat exchange unit 21 is a dry cooler, the dry cooler is preferably arranged close to the condenser 51 of the refrigeration unit 5 and shares the heat-dissipation fan 52 with the condenser 51. By the above designing of the structure, the dry cooler and the condenser 51 for exchanging heat with air are integrated, which is helpful to save the space, and the heat-dissipation fan 52 of the condenser 51 and the heat-dissipation fan 52 of the dry cooler can be shared, which is more helpful to improve the heat dissipation efficiency.

In a further embodiment, the switching valve group 3 may specifically include a first valve port 31, a second valve port 32, a third valve port 33 and a fourth valve port 34. Both ends of the first liquid pipeline 1 are respectively connected to the first valve port 31 and the second valve port 32, and both ends of the second liquid pipeline 2 are respectively connected to the third valve port 33 and the fourth valve port 34.

In a case that the switching valve group 3 is in the first working position, the first valve port 31 is communicated with the second valve port 32, and the third valve port 33 is communicated with the fourth valve port 34. At this time, the first liquid pipeline 1 forms an independent circulation loop through the first valve port 31 and the second valve port 32. The second liquid pipeline 2 forms another independent circulation loop through the third valve port 33 and the fourth valve port 34. The independent circulation loop here means that the liquid circulation does not interfere with each other. In a case that the switching valve group 3 is in the second working position, the second valve port 32 is communicated with the third valve port 33, and the first valve port 31 is communicated with the fourth valve port 34. At this time, one end of the first liquid pipeline 1 is communicated with one end of the second liquid pipeline 2 through the second valve port 32 and the third valve port 33, and the other end of the first liquid pipeline 1 is communicated with the other end of the second liquid pipeline 2 through the first valve port 31 and the fourth valve port 34, so that the first liquid pipeline 1 and the second liquid pipeline 2 are connected in series to form a circulation loop. By designing the switching valve group 3 into the above structural form, it is more convenient to switch the switching valve group 3 between the two working positions, and the structure is simpler. As for the specific structural form, a two-position four-way valve can be used. Of course, it can be understood that in the actual application process, multiple valves can also be used to connect pipelines to realize the switching function of the switching valve group 3 between the two working positions. In the actual application process, it can be specifically configured based on the actual needs, so it is not specifically limited here.

It should be noted that the above two-position four-way valve preferably adopts an electromagnetic valve. By designing the two-position four-way valve into the structure of electromagnetic valve, the control mode can be directly controlled by electronic control unit, which is more convenient.

In some more specific embodiments, with reference to FIGS. 1 to 4, the second liquid pipeline 2 described above may further be provided with a bypass pipeline 4 arranged in parallel with the second heat exchange unit 21. By designing the bypass pipeline 4, whether to short-circuit the second heat exchange unit 21 can be determined based on the actual demand. For example, in a case that the cooling capacity from the first heat exchange unit 11 is sufficient to meet the cooling demands for both the first heat exchange device 13 and the second heat exchange device 23, that is, under the condition of low temperature in the device, the switching valve group 3 may be switched to the second working position at this time, and the bypass pipeline 4 is communicated. In this case, the first liquid pipeline 1 and the second liquid pipeline 2 are connected in series to form a circuit, and the cooling capacity for both the first heat exchange device 13 and the second heat exchange device 23 on the circuit comes from the first heat exchange unit 11. In a case that the device is in a high temperature working condition, the bypass pipeline 4 is cut off, and the second heat exchange unit 21 participates in the heat exchange process. By designing the bypass pipe 4, the control of the thermal management system is more flexible, enabling the heat dissipation requirements for the first heat exchange device 13 and the second heat exchange device 23 to be better met in a low energy consumption mode.

In a further embodiment, the liquid inlet of the bypass pipeline 4 and the second liquid pipeline 2 may be connected to each other through a three-way valve 41, which may be switched back and forth between a first communication status and a second communication status. In a case that the three-way valve is in the first communication status, the bypass pipeline 4 is communicated, and the second heat exchange unit 21 is short-circuited on the second liquid pipeline 2. In a case that the three-way valve is in the second communication status, the bypass pipeline 4 is cut off, and the second heat exchange unit 21 is connected to the second liquid pipeline 2. The design of the three-way valve 41 makes the switching of the bypass pipeline 4 more convenient. In a preferred technical solution, the three-way valve 41 preferably adopts an electromagnetic valve. Of course, it should be understood that the above-mentioned three-way valve 41 is only an example of the connection mode of the bypass pipeline 4 and the second liquid pipeline 2 according to the embodiment of the present application. In the actual application process, multiple combined control valves may be directly arranged on the pipeline where the bypass pipeline 4 and the second heat exchange unit 21 are located, which can be configured based on the actual needs, and are not specifically limited here.

It should be noted that the above-mentioned thermal management system may be specifically applied onto the liquid-cooled energy storage units. In that case, the first heat exchange device 13 of the thermal management system is arranged to exchange heat with the battery pack of the liquid-cooled energy storage unit, and the second heat exchange device 23 is arranged to exchange heat with the converter of the liquid-cooled energy storage unit, so as to realize flexible adjustment and control of heat dissipation between the battery pack and the converter. Of course, it can be understood that the above thermal management system can be applied not only onto the liquid-cooled energy storage units, but also onto other devices with two different cooling requirements, so it is not specifically limited here.

In a further embodiment, in a case that the thermal management system is applied onto a liquid-cooled energy storage unit, the first heat exchange device 13 is arranged to exchange heat with the battery pack of the liquid-cooled energy storage unit, and the second heat exchange device 23 is arranged to exchange heat with the converter of the liquid-cooled energy storage unit. In a case that the switching valve group 3 of the thermal management system is in the second working position, the first heat exchange device 13 and the second heat exchange device 23 are arranged in sequence on the liquid flow pipeline between the liquid outlet of the first heat exchange unit 11 and the liquid inlet of the first heat exchange unit 11, and the first heat exchange device 13 is located upstream of the second heat exchange device 23. By this above designing structure, the thermal management requirements of the battery pack can be better met, as the battery pack has stricter temperature requirements compared to the converter.

In addition, a control method is further provided according to the present application, which is used for controlling the thermal management system described in any one of the above solutions, and the control method specifically includes the following step:
acquiring an external ambient temperature of the device where the thermal management system is applied;
in a case that the external environment temperature is greater than a first preset temperature value, the switching valve group 3 is controlled to switch to the first working position. At this time, the circulation loop having the first liquid pipeline 1 and the circulation loop having the second liquid pipeline 2 are two circulation loops in which the liquid flow circulations do not interfere with each other. The first heat exchange unit 11 transfers the cooling capacity to the first heat exchange device 13 through the first circulation pump 12, and its corresponding heating devices (such as battery packs) are cooled by the first heat exchange device 13. The second heat exchange unit 21 transfers the cooling capacity to the second heat exchange device 23 through the second circulation pump 22, and the corresponding heating devices (such as converters) are cooled by the second heat exchange device 23. In a case that the ambient temperature is lower than the first preset temperature value, the switching valve group 3 is controlled to switch to the second working position, at which time the first liquid pipeline 1 and the second liquid pipeline 2 are connected in series to form a circulation loop. In this case, the cooling capacity of the first heat exchange unit 11 and the second heat exchange unit 12 can be simultaneously supplied to the first heat exchange device 13 and the second heat exchange device 23 through the first circulation pump 12 and the second circulation pump 22, and the corresponding heating devices are cooled by the first heat exchange device 13 and the second heat exchange device respectively.

It should be noted that the above-mentioned specific ways to obtain the external environment temperature can involve manual collection or the use of temperature sensors for automated collection. Similarly, the switching operation of the working position of the switching valve group 3 can be performed manually, or automatically controlled through communication between the controller and the temperature sensors. In the actual application process, the design can be determined based on the actual arrangement requirements, and no more specific restrictions are made here.

Since the above thermal management system has the above technical effects, the control method used for the thermal management system should also have corresponding technical effects, which will not be repeated here.

It should be noted that the first preset temperature value may specifically refer to a liquid return temperature of the first heat exchange unit 11 or a temperature value lower than the preset liquid return temperature of the first heat exchange unit 11. In the actual application process, the settings can be selected based on the actual needs, and no more specific restrictions are made here.

In a further embodiment, in a case that the second liquid pipeline 2 is provided with a bypass pipeline 4 arranged in parallel with the second heat exchange unit 21, the external environment temperature is lower than the first preset temperature value. In a case that the device applied by the thermal management system is in a start-up condition or runs below the second preset temperature value for more than a preset time, the first bypass pipeline 4 is opened. At this time, the second heat exchange unit 21 is short-circuited by the bypass pipeline 4, and the cooling capacity of both the first heat exchange device 13 and the second heat exchange device 23 comes from the first heat exchange unit 11. It should be noted that the second preset temperature value can be set based on the actual demand, mainly to meet the heat dissipation demand of the device applied by the thermal management system in the working mode of low-temperature energy storage for a long time.

In other specific embodiments, in a case that the external environment temperature is lower than the first preset temperature value and the device applied by the thermal management system is in a static state, the first heat exchange unit 11 is closed and the pipeline of the second heat exchange unit 21 remains in communication. At this time, the cooling capacity of the first heat exchange device 13 and the second heat exchange device 23 both come from the second heat exchange unit 21.

In order for the skilled in the art to better understand the technical solution of the present application, the following examples are given in combination with more specific application scenarios.

Taking the first heat exchange unit 11 as the evaporator of the refrigeration unit 5, the second heat exchange unit 12 as the dry cooler, the first heat exchange device 13 as the liquid-cooled battery pack, and the second heat exchange device 23 as the liquid-cooled energy storage converter as an example,
in a case that the liquid-cooled energy storage unit is in the normal working condition, the switching valve group 3 is in the first working position, and the first liquid pipeline 1 and the second liquid pipeline 2 form circulation loops independent from each other. At this time, the liquid-cooled energy storage converter radiates heat through the dry cooler, and the liquid-cooled battery pack radiates heat through the evaporator of the refrigeration unit 5. Since the temperature required for the normal operation of liquid-cooled battery pack is low, it is necessary for the refrigeration unit 5 (refrigerant system) to provide a lower water inlet temperature to cool down and keep cold after heat exchange, while the liquid-cooled energy storage converter has better temperature tolerance, and can make full use of environmental cold energy to dissipate heat, which can save a lot of cold energy of refrigeration units and achieve the effect of reducing energy consumption.

In a case that the liquid-cooled energy storage unit is in the low-temperature working condition, the switching valve group 3 is switched to the second working position. At this time, the first liquid pipeline 1 and the second liquid pipeline 2 are connected in series to form a circulation loop, with the liquid-cooled battery pack and the liquid-cooled energy storage converter being arranged in the series mode, and being normally connected to two sets of heat exchangers: the evaporator and the dry cooler. In a case that the energy storage unit operates at a low temperature (for example, the ambient temperature is significantly lower than the backwater temperature in the liquid-cooled channel of the evaporator), the coolant first passes through the liquid-cooled battery pack and then through the liquid-cooled energy storage converter to meet the thermal requirements of the two types of devices respectively. Furthermore, after passing through the two heat sources, namely, the liquid-cooled battery pack and the liquid-cooled energy storage converter, the coolant first enters the dry cooler and then enters the evaporator. This setup utilizes the ambient cooling capacity to precool the returned water temperature, thereby saving the cooling capacity of the refrigeration unit (i.e., the refrigerant system) for the largest extent.

In a case that the liquid-cooled energy storage unit is in a certain working condition (for example, in a case that the liquid-cooled energy storage unit enters a static state and the external ambient temperature is low), the refrigeration unit 5 (that is, the refrigerant system, such as the fluorine system) can be completely turned off, and the battery pack and the liquid-cooled energy storage converter can be cooled completely by the air cooling capacity, achieving the effect of maximum saving energy.

In a case that the liquid-cooled energy storage unit is in low-temperature start-up condition, the switching valve group 3 is switched to the second working position. At this time, the first liquid pipeline 1 and the second liquid pipeline 2 are connected in series to form a circulation loop, and the liquid-cooled battery pack and the liquid-cooled energy storage converter are in series mode. At this time, only one set of the heat exchangers of the evaporator can be connected by connecting the bypass pipeline 4.

In a case that the liquid-cooled energy storage unit has been stored at low temperature for a long time, both the liquid-cooled battery pack and the liquid-cooled energy storage converter remain in a low temperature state. In order to prevent heat loss, the bypass pipeline 4 may be opened to directly shield the dry cooler. At the same time, the system drives the liquid-cooled energy storage converter to generate reactive heat to warm the coolant. The heat from the liquid-cooled energy storage converter is used to heat the liquid-cooled battery pack, which improves the efficiency of the system and reduces the demand on the heating rods for heating the heating rod.

It should be noted that the embodiments in this specification are described in a progressive way, each of the embodiments emphasizes the differences from others, and the same or similar parts among the embodiments can be referred to each other.

It should be understood that if "system", "device", "unit" and/or "module" are used herein, it is merely a method for distinguishing different assemblies, elements, components, portions or assembly at different levels. However, if other expressions can realize the same purpose, they may be replaced by other expressions.

As shown in the present application and the claims, the words "a", "one", "one type" and/or "this" are not specifically referring to the singular, but may also include the plural, unless the context clearly indicates exceptions. Generally speaking, the terms "include" and "comprise" only indicate that the steps and elements that have been clearly identified are included, and these steps and elements do not constitute an exclusive list. A Method or an apparatus may also contain other steps or elements. The elements limited by the statement "comprising (including) a..." do not exclude the existence of other identical elements exist in the process, method, product or apparatus that includes the elements.

In the description of the embodiments of the present application, unless otherwise specified, "/" means or, for example, A/B can mean A or B. The "and/or" herein is only an association relationship that describes the associated objects, which means that there may be three kinds of relationships, for example, A and/or B may mean that there are three cases: A alone, A and B at the same time, and B alone. In addition, in the description of the embodiments of the present application, "multiple" refers to two or more.

The terms "first", "second" and the like are for purpose of description, and should not be interpreted as indicating or implying relative importance or implying the number of the indicated technical features. Therefore, a feature defined by "first" and "second" may explicitly or implicitly be one or more in number.

If a flowchart is used in the present application, the flowchart is used to explain the operation performed by the system according to the embodiment of the present application. It should be understood that the preceding or subsequent operations are not necessarily performed accurately in sequence. Instead, the steps can be processed in reverse order or simultaneously. In addition, other operations can be added to these procedures, or one or more operations can be removed from these procedures.

The principle and the embodiments of the present application are illustrated herein by specific examples. The above description of the examples is only intended to facilitate the understanding of the core concept of the present application. It should be noted that, several improvements and modifications may be made by those skilled in the art to the present application without departing from the principle of the present application, and these improvements and modifications also fall within the protection scope of the claims of the present application.

## Claims

1. A thermal management system, comprising a first liquid pipeline (1), a second liquid pipeline (2) and a switching valve group (3), wherein
a first heat exchange unit (11), a first circulation pump (12) and a first heat exchange device (13) are connected in series on the first liquid pipeline (1);
a second heat exchange unit (21), a second circulation pump (22) and a second heat exchange device (23) are connected in series on the second liquid pipeline (2);
the switching valve group (3) is connected between the first liquid pipeline (1) and the second liquid pipeline (2);
the switching valve group (3) is configured to be switched between a first working position and a second working position, and in a case that the switching valve group (3) is in the first working position, liquid flow circulations of the first liquid pipeline (1) and the second liquid pipeline (2) do not interfere with each other, and in a case that the switching valve group (3) is in the second working position, the first liquid pipeline (1) and the second liquid pipeline (2) are connected in series.

2. The thermal management system according to claim 1, wherein the switching valve group (3) comprises a first valve port (31), a second valve port (32), a third valve port (33), and a fourth valve port (34), both ends of the first liquid pipeline (1) are respectively connected to the first valve port (31) and the second valve port (32), and both ends of the second liquid pipeline (2) are respectively connected to the third valve port (33) and the fourth valve port (34);
in a case that the switching valve group (3) is in the first working position, the first valve port (31) is communicated to the second valve port (32), and the third valve port (33) is communicated to the fourth valve port (34); and
in a case that the switching valve group (3) is in the second working position, the second valve port (32) is communicated to the third valve port (33), and the first valve port (31) is communicated to the fourth valve port (34).

3. The thermal management system according to claim 1, wherein the first liquid pipeline (1) is further provided with a heater (55), which is located between a liquid outlet of the first heat exchange unit (11) and a liquid inlet of the first heat exchange device (13).

4. The thermal management system according to claim 1, further comprising a refrigeration unit (5), wherein the first heat exchange unit (11) is configured as an evaporator of the refrigeration unit (5), the condenser (51) of the refrigeration unit (5) is connected in series with the second liquid pipeline (2) and positioned upstream of the second heat exchange device (23), while the second heat exchange unit (21) is positioned downstream of the second heat exchange device (23).

5. The thermal management system according to claim 4, wherein the condenser is configured as a plate heat exchanger, and the second heat exchange unit (21) is configured as an air-cooled condenser.

6. The thermal management system according to claims 1 to 5, wherein the second liquid pipeline (2) is further provided with a bypass pipeline (4) arranged in parallel with the second heat exchange unit (21).

7. The thermal management system according to claim 6, wherein the liquid inlet of the bypass pipeline (4) is connected with the second liquid pipeline (2) through a three-way valve (41), and the three-way valve (41) is configured to be switched between a first communication status and a second communication status;
in a case that the three-way valve is in the first communication status, the bypass pipeline (4) is communicated, and the second heat exchange unit (21) is short-circuited on the second liquid pipeline (2); and
in a case that the three-way valve is in the second communication status, the bypass pipeline (4) is cut off, and the second heat exchange unit (21) is connected to the second liquid pipeline (2).

8. The thermal management system according to claim 1, wherein the thermal management system is applied onto a liquid-cooled energy storage unit, the first heat exchange device (13) is arranged to exchange heat with the battery pack of the liquid-cooled energy storage unit, and the second heat exchange device (23) is arranged to exchange heat with the converter of the liquid-cooled energy storage unit.

9. The thermal management system according to claim 8, wherein in a case that the switching valve group (3) is in the second working position, the first heat exchange device (13) and the second heat exchange device (23) are sequentially arranged on the liquid flow pipeline between a liquid outlet and a liquid inlet of the first heat exchange unit (11), and the first heat exchange device (13) is positioned upstream of the second heat exchange device (23).

10. A control method for controlling the thermal management system according to any one of claims 1 to 9, wherein the control method comprises:
acquiring an external ambient temperature of the device applied by the thermal management system;
in a case that the external environment temperature is greater than a first preset temperature value, the switching valve group (3) is controlled to switch to a first working position, and in a case that the external environment temperature is less than the first preset temperature value, the switching valve group (3) is controlled to switch to a second working position.

11. The control method according to claim 10, wherein the first preset temperature value refers to a liquid return temperature of the first heat exchange unit (11) or a temperature value lower than a preset liquid return temperature of the first heat exchange unit (11).

12. The control method according to claim 10, wherein in a case that the second liquid pipeline (2) is provided with a bypass pipeline (4) arranged in parallel with the second heat exchange unit (21), the external ambient temperature is less than the first preset temperature value, and in a case that the device applied by the thermal management system is in a startup condition or runs below the second preset temperature value for more than a preset time, the first bypass pipeline (4) is communicated.

13. The control method according to claim 10, wherein in a case that the external ambient temperature is lower than a first preset temperature value and the device using the thermal management system is in a standby state, the first heat exchange unit (11) is turned off, while the pipeline containing the second heat exchange unit (21) remains in communication.
